# EUROPÄISCHE PATENTSCHRIFT

(11) **EP 0 718 886 B1**
(45) Veröffentlichungstag und Bekanntmachung des Hinweises auf die Patenterteilung: **30.08.2000**
(21) Anmeldenummer: 95120111.0
(22) Anmeldetag: 19.12.1995
(51) Int. Cl.: H01L 25/07, H01L 23/24

(54) **Leistungshalbleitermodul**
Semiconductor power module
Module à semi-conducteur de puissance

(30) Priorität: 24.12.1994 DE 4446527
(43) Veröffentlichungstag der Anmeldung: 26.06.1996
(73) Patentinhaber: IXYS Semiconductor GmbH, D-68623 Lampertheim (DE)
(72) Erfinder: Neidig, Arno, D-68723 Plankstadt (DE); Kinzel, Peter, D-64572 Büttelborn (DE)
(74) Vertreter: Luderschmidt, Schüler & Partner GbR

(56) Entgegenhaltungen:
- EP-A- 0 205 746
- EP-A- 0 292 848
- EP-A- 0 384 482
- PATENT ABSTRACTS OF JAPAN vol. 011 no. 023 (E-473) ,22.Januar 1987 & JP-A-61 193471 (HITACHI LTD) 27.August 1986,

## Beschreibung

Die Erfindung bezieht sich auf ein Leistungshalbleitermodul nach dem Oberbegriff des Anspruchs 1.

Solche Module sind geeignet zur Realisierung von Brücken oder Teilbrücken einer Stromrichterschaltung.

Module dieser Bauart, also mit Kunststoffgehäuse und einem Kupfer/Keramik-Substrat als Boden, haben einige erstrebenswerte Eigenschaften, wie beispielsweise ein vergleichsweise niedriges Gewicht und gute Wärmeleiteigenschaften zur Wärmeabfuhr von wärmeerzeugenden Bauelementen im Inneren des Moduls durch das dünne Bodensubstrat hindurch zu einem Kühlkörper. Das Bodensubstrat ist jedoch bruchempfindlich und kann sich unter Umständen verformen, wodurch die Wärmeableitung beeinträchtigt werden kann. Um solchen Problemen zu begegnen wurden bereits mehrere Vorschläge zur Modulgestaltung bekannt, die teilweise auch im Rahmen der erfindungsgemäß vorgeschlagenen Modulausführung Anwendung finden können.

Ein Modul gemäß dem Oberbegriff des Anspruchs 1 ist aus der DE 31 27 457 C2 bekannt. Bei diesem Modul ist ein als Kupfer-Keramik-Kupfer-Sandwich ausgeführtes Substrat als Bodenebene in ein Kunststoffgehäuse eingesetzt. Durch einen solchen mehrschichtigen Aufbau des Substrats wird die Bruchgefahr gegenüber einem Keramikboden bereits erheblich vermindert. Das rahmenförmige Kunststoffgehäuse weist innere Verstrebungen auf. Das mehrschichtige Substrat ist nach einem Direktverbindungsverfahren zur Keramik-Kupferverbindung hergestellt und mit Halbleiterbauelementen bestückt. Das dem Modulinneren zugewandte Stück des Substrats ist zuerst mit einer als Weichverguß eingefüllten Silikonharzschicht versehen. Darüber ist ein Epoxydharz als Hartverguß zur Verkapselung eingefüllt. Die Höhe des Weichvergusses liegt deutlich unterhalb der Unterkante der inneren Verstrebungen, damit sich der Hartverguß gleichmäßig in den durch die Verstrebungen gebildeten Kammern verteilen kann.

Bei einem Modul gemäß EP-B1-01 18 022 ist als weiterer Maßnahme zur Minderung der Bruchgefahr während der Montage des Moduls auf einem Kühlkörper vorgesehen, daß an das Kunststoffgehäuse angeformte Befestigungsflansche zwischen den Wandungen des Gehäuserahmens und den Befestigungslöchern der Laschen mit Schlitzen versehen sind. Dadurch wird wirksam vermieden, daß sich das mechanische Spannungsfeld im Bereich der Befestigungsschrauben auf das Substrat überträgt.

Es sind auch bereits mehrere Maßnahmen bekannt, mit denen einer konkaven Durchbiegung des Substrats, die den Wärmeübergang verschlechtern würde, entgegengewirkt werden kann. In der EP-B1-02 05 746 ist als eine solche Maßnahme die Anordnung von Stützen auf dem Substrat oder auf Bauelementen zu entnehmen. Das Modulinnere ist dabei teilweise mit einer Weichvergußmasse und teilweise mit einer darüber gegossenen Hartvergußmasse gefüllt. Die Stützen ragen in die Hartvergußmasse hinein, so daß eine starre Verbindung zwischen dem dort haubenförmigen Kunststoffgehäuse und ausgewählten Substratflächen gegeben ist und somit Kräfte übertragbar sind.

Aus der DE 40 01 554 A1 ist eine Gestaltung des Kunststoffgehäuses mit angeformten Stützen bekannt, wobei die angeformten Stützen an mehreren Stellen direkt auf das Substrat drücken.

Aus der EP-B1-02 92 848 ist ein Modul bekannt, bei dem das Kunststoffgehäuse innere Verstrebungen aufweist, die aber nicht als Stütze für das Substrat dienen, sondern zur Führung von Anschlußlaschen angeordnet sind.

Wie bereits erwähnt, werden Leistungshalbleitermodule im allgemeinen auf Kühlkörper montiert, um Verlustleistungen abzuführen. Zur Verbesserung des thermischen Übergangs zwischen Modulboden und Kühlkörperoberfläche verwendet man vorzugsweise sogenannte Wärmeleitpasten. Das sind Gemische aus Metalloxiden und Silikonölen oder Estern. Diese können sehr zähflüssig sein. Insbesondere wenn die Paste zu dick und ungleichmäßig auf den Modulboden oder den Kühlkörper aufgetragen wird, kann der Fall eintreten, daß sich die Paste nicht sofort beim Anpressen des Moduls auf den Kühlkörper dünn verteilt; besonders wenn das Anpressen z.B. mit Hilfe elektrischer oder pneumatischer Schrauber sehr schnell erfolgt. In einem solchen Fall muß sich das Substrat zumindest vorübergehend nach innen biegen und es kann bei zu starker mechanischer Belastung brechen. Die Nachgiebigkeit des Substrats zum Innenraum hin ist vor allem durch die Art der Vergießtechnik bedingt. Bei der üblichen Vergießtechnik wird nach dem Einbringen und Vernetzen des Weichvergusses der Hartverguß eingebracht und bei relativ hohen Temperaturen oberhalb 100° C ausgehärtet. Während des Aushärteprozesses dehnt sich der Weichverguß stark aus. Die Volumendehnung von Silikonharzen liegt typisch bei etwa 10%, wenn die Temperaturerhöhung 100 K beträgt. Nach dem Aushärten des Hartvergusses und dem Abkühlen schrumpft der Weichverguß auf sein ursprüngliches Volumen und hinterläßt einen merklichen Spalt zwischen Weich- und Hartverguß. Die Nachgiebigkeit des Substrats ist jedoch nicht nur durch diesen Spalt, sondern auch durch die Verwendung von weichen Silikongelen bedingt. Dadurch kann der unmittelbar über dem Substrat liegende weiche Verguß einer von außen auf das Substrat wirkenden Kraft keine ausreichende Gegenkraft (Gegendruck) bieten.

Zur Lösung dieses Problems können Stützen der oben beschriebenen bekannten Art wenig beitragen, da sie nur auf engbegrenzte Substratflächen eine Gegenkraft erzeugen können. Im Fall ungleichmäßig verteilter Wärmeleitpaste können lokal unzulässige mechanische Spannungen im Substrat auftreten. In das Gehäuse durch entsprechende Gehäusegestaltung integrierte Stützen haben außerdem den Nachteil, daß das Gehäuse auf das Substrat-Layout und die Bestückung abgestimmt sein muß, wodurch ein solches Gehäuse nicht universell einsetzbar ist.

Der Erfindung liegt die Aufgabe zugrunde, ein Leistungshalbleitermodul gemäß dem Oberbegriff des Anspruchs 1 anzugeben, das besser als bekannte Module gegen eine bei der Modulmontage auftretende Bruchgefahr geschützt ist.

Diese Aufgabe wird durch ein Modul mit den Merkmalen des Anspruchs 1 gelöst.

Vorteilhafte Ausgestaltungen sind in weiteren Ansprüchen angegeben und der unten stehenden Beschreibung eines Ausführungsbeispiels anhand der Zeichnung zu entnehmen.

Der im ausgehärteten Zustand gummiartige Weichverguß mit einer Shore-Härte ≥ 20 (Shore-Härte A) und mit darin eintauchenden Gehäuseverstrebungen bewirkt vorteilhaft einerseits eine hohe Festigkeit gegen ein Verwölben des Substrats zum Modulinnenraum hin und vermeidet andererseits eine lokal unterschiedliche Durchbiegung des Substrats. Außerdem ist die vorgeschlagene Maßnahme kostengünstig zu realisieren unter Vermeidung zusätzlicher Komponenten, die während der Modulfertigung zu justieren wären.

Eine weitere Erläuterung der Erfindung erfolgt nachstehend anhand von in den Zeichnungsfiguren dargestellten Ausführungsbeispielen.

Es zeigt:
- Fig. 1: eine Gesamtansicht eines fertiggestellten Leistungshalbleitermoduls,
- Fig. 2 und 3: Schnitte durch das Modul,
- Fig. 4: Draufsicht auf ein Modulgehäuse,
- Fig. 5 bis 7: Schnitte durch das Modulgehäuse,
- Fig. 8: Leistungshalbleitermodul mit einer Variante zur Verstrebungs-Ausführung.

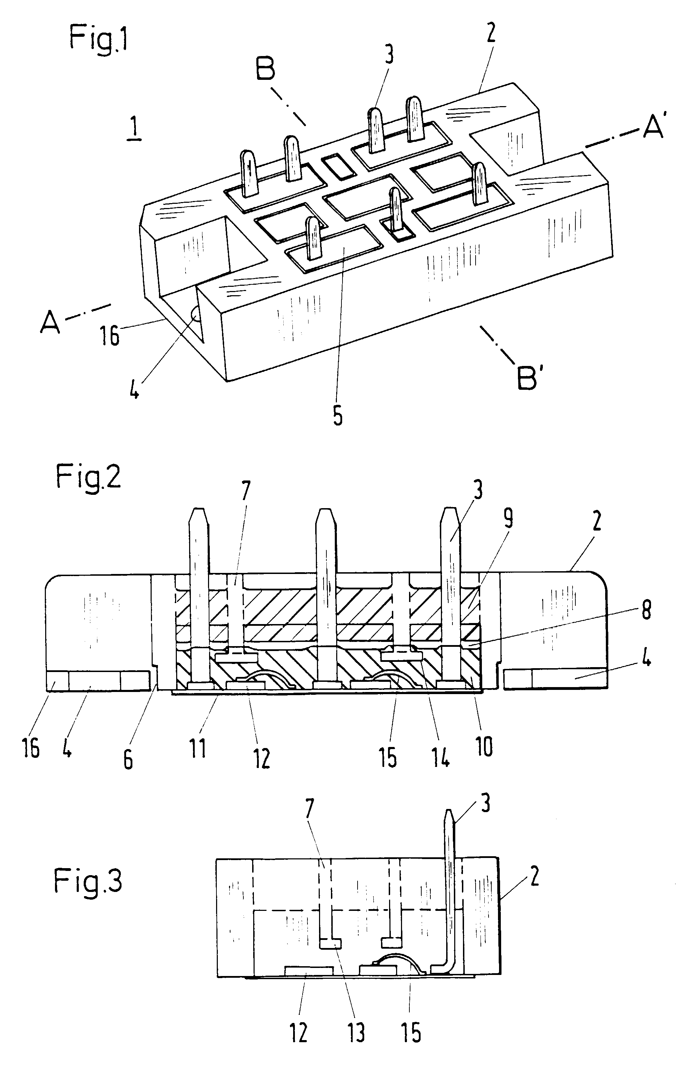

Fig. 1 zeigt eine äußere Ansicht eines Leistungshalbleitermoduls 1 . Sein Kunststoffgehäuse 2 weist auf der Oberseite Öffnungen 5 zum Einfüllen von Vergußmassen auf, sowie Befestigungsflansche 16 mit runden oder schlitzförmigen Befestigungsöffnungen 4. An der Oberseite ragen elektrische Anschlüsse 3 aus dem Modul. In Fig. 1 sind außerdem Schnittebenen A-A' und B-B' eingetragen.

Weitere Einzelheiten zum Modulaufbau sind dem in Fig. 2 dargestellten Schnitt durch die Ebene A-A' zu entnehmen. In das Gehäuse 2 ist in der Bodenebene ein Substrat 11 eingesetzt. Das Substrat 11 ist vorzugsweise ein mehrschichtiges Substrat, das nach einem Direktverbindungsverfahren (direct bonding) hergestellt ist durch Übereinanderschichten einer Kupferfolie, einer Keramikplatte und einer weiteren Kupferfolie. An das Substrat 11 kann aber auf der Unterseite auch zusätzlich zur Verstärkung eine z.B. 3 mm dicke Kupferplatte angelötet sein. Auf der dem Modulinneren zugewandten Seite trägt das Substrat 11 Aufbauten, wie Halbleiterbauelemente 12, Bonddrähte 15 und Anschlüsse 3. Die Bauelemente 12 sind durch einen Weichverguß 10 abgedeckt und darüber befindet sich ein Hartverguß 9. Während der Herstellung entsteht durch Schrumpfprozesse ein Spalt 8 zwischen den Vergußmassen 9, 10.

Das Gehäuse 2 weist Verstrebungen 7 auf, von denen wenigstens ein Teil so ausgeführt ist, daß das untere Ende in den Weichverguß 10 ragt. Die in den Weichverguß eintauchenden Verstrebungen 7 befinden sich vorzugsweise im mittleren Bereich des Moduls 1, wo das Substrat 11 ohne Stützmaßnahmen am meisten nachgeben würde. Wesentlich ist auch, daß dadurch ein gleichmäßigerer innerer Gegendruck erreicht wird. Die Verstrebungen 7 haben keine Berührung mit dem Substrat oder Aufbauten auf dem Substrat.

Soweit durch die Anzahl der Verstrebungen 7 oder deren Wandstärke keine ausreichende Gegenkraft erzielbar ist, können abhängig von der Härte der Weichvergußmasse L-förmige Verbreiterungen 13 (Fig. 3) oder T-förmige Verbreiterungen 14 der Verstrebungen 7 an dem in den Weichverguß tauchenden Teil vorgesehen werden.

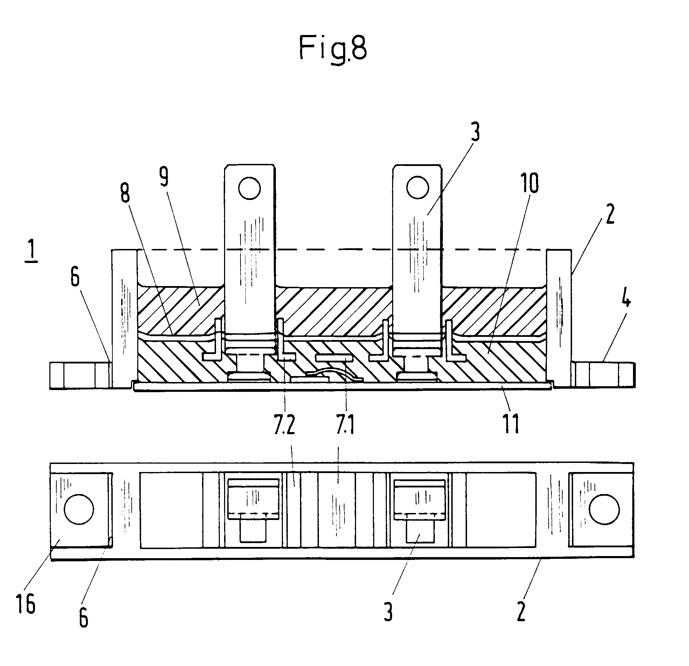

Aus den Fig. 2 und 8 ist außerdem ersichtlich, daß das Gehäuse 2 in einem an die Befestigungsflansche 16 angrenzenden Wandungsbereich Schlitze 6 aufweisen kann.

Fig. 3 zeigt einen Schnitt durch die Ebene B-B', jedoch ohne Darstellung von Vergußmassen. In Fig. 3 sind anstelle der in Fig. 2 gezeigten ankerförmigen Verstrebungen 7, 14 L-förmige Verstrebungen 7, 13 gezeigt.

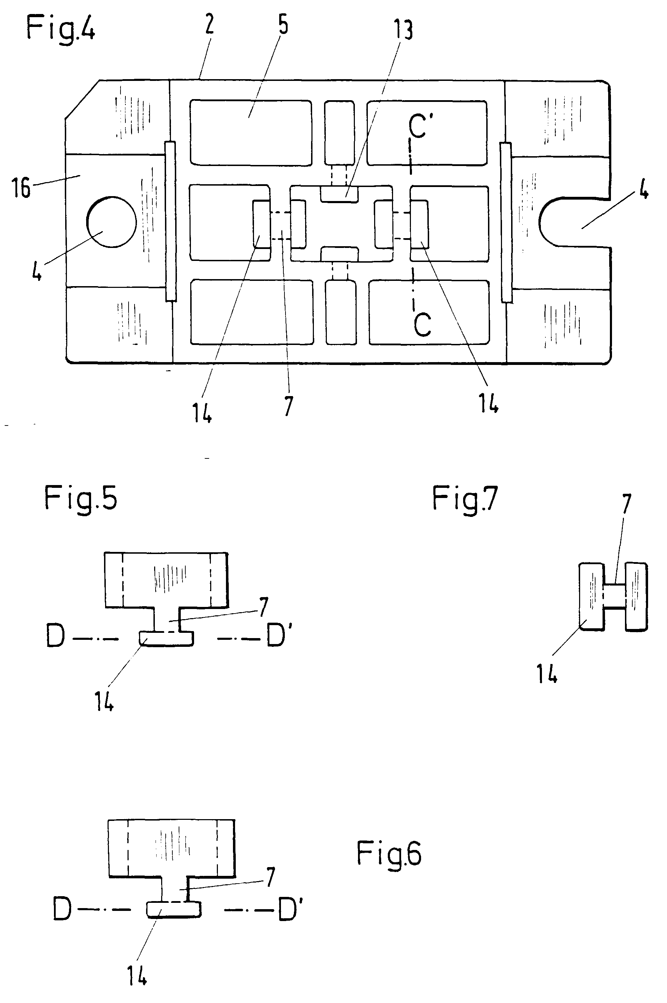

Fig. 4 zeigt in einer Draufsicht auf das Gehäuse 2 nochmals die unterschiedlichen Ausführungen von Verstrebungen 7 mit Verbreiterungen 13, 14. Außerdem ist eine Schnittebene C-C' eingetragen.

Fig. 5 zeigt einen Schnitt durch eine Verstrebung in der Ebene C-C'. Fig. 6 zeigt im Vergleich zur Fig. 5 eine Variante der ankerförmig ausgeführten Verstrebung, wobei die Unterseite der Verbreiterung 14 eine Rundung aufweist, wodurch sich beim Aushärten der Vergußmasse 10 ein Einschluß von Luftblasen vermeiden läßt. Fig. 7 zeigt einen Schnitt durch eine Verstrebung in der in den Fig. 5 und 6 angegebenen Schnittebene D-D'.

Fig. 8 zeigt in einem Schnittbild und einer Draufsicht alternative Ausführungen von Verstrebungen. Dabei ist als eine erste Ausführungsform eine quer verlaufende Verstrebung 7.1 dargestellt, die vollständig innerhalb des Weichvergusses 10 liegt. Aus der Draufsicht ist ersichtlich, daß auch diese Verstrebung 7.1 Teil des Kunststoffgehäuses 2 ist. Aus Fig. 8 ist eine weitere Gestaltungsmöglichkeit für Verstrebungen zu entnehmen, nämlich Verstrebungen 7.2 mit Führungsfunktion. Diese Verstrebungen 7.2 sind so angeordnet, daß sie Anschlüsse 3, insbesondere während der Modulherstellung führen können.

Ein erfindungsgemäßes Leistungshalbleitermodul kann auf nachstehende Weise hergestellt werden. Ein beispielsweise 5x5 cm²-großes DCB(direct copper bond)-Substrat wird - wie aus den eingangs genannten Druckschriften bekannt - mit Halbleiterbauelementen (Chips) und Anschlüssen bestückt und in das Kunststoffgehäuse eingeklebt. Anschließend wird Weichverguß eingefüllt. Geeignet sind dafür Zweikomponenten-Harze, deren Festigkeit durch Einstellen des Mischungsverhältnisses eingestellt werden kann. Beispielsweise kann das Produkt RTV 615 von General Electric eingesetzt werden im Verhältnis 1:1 seiner beiden Komponenten. Geeignet ist beispielsweise auch ein Silikongel, wie das Produkt Silgel 612 der Fa. Wacker, mit einem Mischungsverhältnis, mit dem eine ähnlich hohe Festigkeit wie beim vorgenannten Verguß erreicht wird. Dieser Weichverguß ist ein schon bei Raumtemperatur vernetzender Silikonkautschuk; der Vernetzungsprozeß verläuft bei höheren Temperaturen jedoch schneller. Die Vergußhöhe wird so gewählt, daß nur ein unterer Teil der Verstrebungen, der vorzugsweise Verbreiterungen aufweist, in den Verguß eintaucht, während der übrige Teil der inneren Gehäuseverstrebungen noch aus dem Verguß herausragt.

In einem weiteren Arbeitsgang wird Epoxidharz als Hartverguß eingebracht und bei etwa 130° C ausgehärtet. Bei dieser Temperatur dehnt sich der Weichverguß (Silikonverguß) aus und hinterläßt nach dem Aushärten und Abkühlen einen Spalt von etwa 1 mm Breite zur Unterseite des Epoxidharzes.

Die Gestaltung der erfindungsgemäß anzuordnenden Verstrebungen mit gegebenenfalls Verbreiterungen, ist von mehreren Anforderungen abhängig, wie z.B. von der Substratgröße, der Lage externer und interner Anschlüsse sowie spritztechnischer Anforderungen.

Die Erfindung ist auch vorteilhaft anwendbar bei Modulen, die nur eine Weichvergußmasse besitzen und bei denen auf eine Hartvergußmasse ganz verzichtet wird.

Das Leistungshalbleitermodul ist zur Montage auf einen Kühlkörper vorgesehen, wobei Wärmeleitpaste entweder auf den Modulboden oder den Kühlkörper aufgetragen wird. Dabei möglicherweise auftretenden Druckkräften auf das Substrat wirken die im gummiartigen Weichverguß befindlichen Verstrebungsteile entgegen. Der vorerwähnte Spalt zwischen den beiden Vergußmassen wirkt sich dabei nicht aus, da die Abstützung vom Weichverguß aus erfolgt.

## Patentansprüche

1. Leistungshalbleitermodul (1) mit einem Kunststoffgehäuse (2) mit inneren Verstrebungen (7), in dessen Bodenebene ein Substrat (11), insbesondere ein metallisches Substrat oder ein Metall/Keramik-Mehrschichtsubstrat eingesetzt ist, das Substrat (11) auf der Modulinnenseite mit Bauelementen (12) und Anschlüssen (3) bestückt ist, und wobei das Modul einen Weichverguß (10) und einen Hartverguß (9) aufweist, dadurch gekennzeichnet, daß
a) für den Weichverguß (10) eine Weichvergußmasse gewählt ist, die im ausgehärteten Zustand eine gummiartige Konsistenz aufweist, mit einer Shore-Härte von ≥ 20 (Shore-Härte A), und
b) die Verstrebungen (7, 7.1., 7.2) ganz oder teilweise im Weichverguß (10) angeordnet sind und keine direkte Berührung mit dem Substrat (11) oder darauf befindlichen Aufbauten (3, 12, 15) haben, wobei
b1) Verstrebungen (7, 7.2) eingesetzt sind, die gegenüber der Ebene des Substrats (11) senkrecht verlaufend angeordnet sind und an ihrem dem Substrat (11) zugewandten Ende eine L- oder T-förmige Verbreiterung (13, 14) aufweisen, und/oder
b2) auf die Ebene des Substrats (11) bezogen horizontal verlaufende, vollständig innerhalb des Weichvergusses liegende Verstrebungen (7.1) angeordnet sind.

2. Leistungshalbleitermodul nach Anspruch 1, dadurch gekennzeichnet, daß die L-förmigen Verstrebungen (7.2) im Gehäuse (2) in solcher Weise angeordnet sind, daß sie geeignet sind zur Führung von Anschlüssen (3).

3. Leistungshalbleitermodul nach einem der vorstehenden Ansprüche, dadurch gekennzeichnet, daß das Gehäuse (2) in Wandungsbereichen zwischen angeformten Befestigungsflanschen (16) und Gehäusewänden mit Schlitzen (6) versehen ist.

4. Leistungshalbleitermodul nach einem der vorstehenden Ansprüche, dadurch gekennzeichnet, daß ein Metall/Keramik-Mehrschichtsubstrat (11) eingesetzt ist, das auf seiner Unterseite zusätzlich mit einer Bodenplatte aus Metall verbunden ist.

5. Leistungshalbleitermodul nach einem der vorstehenden Ansprüche, dadurch abgewandelt, daß kein Hartverguß, sondern nur ein Weichverguß (10) vorhanden ist.

## Claims

1. Power semiconductor module (1) having a plastic housing (2) with internal struts (1), in the bottom plane of which a substrate (11), especially a metallic substrate or a metal/ceramic multilayer substrate is fitted, the substrate (11) being equipped on the inside of the module with components (12) and terminals (3), and the module having a soft encapsulation (10) and a hard encapsulation (9) characterized in that,
a) for the soft encapsulation (10) a soft casting compound is selected which has a rubber-like consistency in the cured state, with a Shore hardness of ≥ 20 (Shore hardness A), and
b) the struts (7, 7.1, 7.2) are fully or partly arranged in the soft encapsulation (10) and have no direct contact with the substrate (11) or structures (3, 12, 15) located thereon,
b1) struts (7, 7.2) being used which are arranged extending perpendicularly with respect to the plane of the substrate (11) and having an L-T-shaped transverse extension (13, 14) on their end facing the substrate (11), and/or
b2) struts (7.1) being arranged, extending horizontally with respect to the plane of the substrate (11) and located completely within the soft encapsulation.

2. Power semiconductor module according to Claim 1, characterized in that the L-shaped struts (7.2) are arranged in the housing (2) in such a way that they are suitable for guiding terminals (3).

3. Power semiconductor module according to one of the preceding claims, characterized in that the housing (2) is provided with slits (6) in wall regions between integrally moulded fastening flanges (16) and housing walls.

4. Power semiconductor module according to one of the preceding claims, characterized in that a metal/ceramic multilayer substrate (11) is fitted, which is additionally connected on its lower side to a metal baseplate.

5. Power semiconductor module according to one of the preceding claims, modified in that no hard encapsulation, but only a soft encapsulation (10) is present.

## Revendications

1. Module de semi-conducteur de puissance (1) avec un boîtier en plastique (2) avec entretoisements internes (7), dans le plan de fond duquel un substrat (11), en particulier un substrat métallique ou un substrat à plusieurs couches métal/céramique est mis en place, le substrat (11) sur le côté intérieur de module est équipé de composants (12) et de connexions (3), et où le module présente un scellement souple (10) et un scellement dur (9), caractérisé en ce que
a) pour le scellement souple (10), il est choisi une masse de scellement souple qui, à l'état durci, présente une consistance de type caoutchouc, avec une dureté Shore de ≥ 20 (dureté Shore A), et
b) les entretoisements (7, 7.1., 7.2) sont disposés totalement ou partiellement dans le scellement souple (10) et n'ont aucun contact direct avec le substrat (11) ou avec les éléments (3, 12, 15) qui sont situés dessus, où
b1) des entretoisements (7, 7.2) sont mis en oeuvre, qui sont disposés verticalement par rapport au plan du substrat (11) et présentent, sur leur extrémité tournée vers le substrat (11), un élargissement (13, 14) en forme de L ou de T, et/ou
b2) des entretoisements (7.1) sont disposés horizontalement par rapport au plan du substrat (11), complètement situés à l'intérieur du scellement souple.

2. Module de semi-conducteur de puissance selon la revendication 1, caractérisé en ce que les entretoisement (7.2) en forme de L sont disposés dans le boîtier (2) de telle sorte qu'ils sont appropriés pour le guidage de connexions (3).

3. Module de semi-conducteur de puissance selon l'une des revendications précédentes, caractérisé en ce que le boîtier (2) est muni de fentes (6) dans des zones de paroi situées entre des brides de fixation formées (16) et des parois de boîtier.

4. Module de semi-conducteur de puissance selon l'une des revendications précédentes, caractérisé en ce qu'un substrat multicouche métal/céramique (11) est utilisé, et en outre relié sur son côté inférieur à une plaque de fond en métal.

5. Module de semi-conducteur de puissance selon l'une des revendications précédentes, modifié en ce sens qu'aucun scellement dur, mais uniquement un scellement souple (10) est utilisé.
